Europäisches Patentamt

(19) European Patent Office  (11) Numéro de publication: **0 186 248**

Office européen des brevets  **B1**

(12) **FASCICULE DE BREVET EUROPÉEN**

(45) Date de publication du fascicule du brevet:  (51) Int. Cl.⁴: **G 08 C 17/00**
15.11.89

(21) Numéro de dépôt: **85202082.5**

(22) Date de dépôt: **16.12.85**

(54) Dispositif récepteur de télécommande utilisant une onde porteuse modulée.

(30) Priorité: **28.12.84 FR 8419980**

(43) Date de publication de la demande:
**02.07.86 Bulletin 86/27**

(45) Mention de la délivrance du brevet:
**15.11.89 Bulletin 89/46**

(84) Etats contractants désignés:
**DE FR GB IT**

(56) Documents cité:
EP-A-0 082 347
DE-A-3 332 667
US-A-4 313 212

PATENTS ABSTRACTS OF JAPAN, vol. 7, no. 243 (E-207) 1388 , 28 octobre 1983; & JP - A - 58 131 891 (MATSUSHITA DENKI SANGYO K.K.) 05-08-1983
IEEE TRANSACTIONS ON CONSUMER ELECTRONICS, vol. CE-30, no. 3, août 1984, pages 481-487, IEEE, New York, US; U. APETZ et al.: "Modular software and hardware design concept for synthesizer tuning and control systems"

(73) Titulaire: **LA RADIOTECHNIQUE PORTENSEIGNE, 51, Rue Carnot, F-92150 Suresnes (FR)**
(84) Etats contractants désignés: **FR**

(73) Titulaire: **N.V. Philips' Gloeilampenfabrieken, Groenewoudseweg 1, NL- 5621 BA Eindhoven (NL)**
(84) Etats contractants désignés: **DE GB IT**

(72) Inventeur: **Calvet, Jean- Claude, SOCIETE CIVILE S.P.I.D. 209, rue de l'Université, F-75007 Paris (FR)**
Inventeur: **Mauge, Jacques, SOCIETE CIVILE S.P.I.D. 209, rue de l'Université, F-75007 Paris (FR)**

(74) Mandataire: **Caron, Jean, SOCIETE CIVILE S.P.I.D. 209, rue de l'Université, F-75007 Paris (FR)**

## Description

La présente invention concerne un dispositif récepteur de télécommande utilisant une onde porteuse modulée contenant des informations de télécommande, et comportant un poste récepteur, muni d'un oscillateur local, et un démodulateur qui délivre en sortie les ordres de télécommande sous forme d'informations digitales.

L'invention trouve une application particulièrement avantageuse dans le domaine de la télécommande d'installations domestiques et industrielles, notamment la télécommande d'organes de coupure.

Un dispositif récepteur de télécommande conforme au préambule est connu du brevet FR-A-2 375 674. Ce dispositif est constitué par un poste émetteur-récepteur de commande qui envoie des ordres de télécommande à une pluralité de postes émetteurs-récepteurs d'exécution qui, à leur tour, envoient au poste émetteur-récepteur de commande des informations relatives à l'exécution des ordres de commande reçus. Toutefois, ce dispositif présente l'inconvénient d'exiger un grand nombre de postes à la fois émetteurs et récepteurs, ce qui conduit à un dispositif lourd et coûteux.

Le but de la présente invention est de remédier à cet inconvénient en proposant un dispositif ne nécessitant qu'un poste uniquement émetteur pour la commande et qu'un seul poste récepteur pour l'exécution.

On connaît également de la demande DE-3 332 667 un dispositif récepteur de télécommande utilisant une onde porteuse modulée contenant des informations de télécommande et comportant un poste récepteur, muni d'un oscillateur local, et un démodulateur qui délivre en sortie les ordres de télécommande sous forme d'informations digitales, dispositif comportant également, d'une part, un microprocesseur permettant, entre autres, de gérer les ordres de télécommande à partir des informations digitales fournies par le démodulateur, et, d'autre part, des moyens d'accord et de verrouillage de la fréquence de l'oscillateur local sur la fréquence de l'onde porteuse.

Ainsi, le microprocesseur permet de regrouper sous un volume réduit, et de façon bon marché, toutes les fonctions devant être réalisées par le dispositif récepteur selon l'invention.

Par ailleurs, l'article "Modular software and hardware design concept for synthesizer tuning and control systems" paru dans IEEE Transactions and consumer Electronics, Vol. CE-30, n°3, Août 1984, pages 481 - 487 enseigne que lesdits moyens d'accord et de verrouillage sont réalisés par un synthétiseur de fréquence, en coopération avec un dispositif d'incrémentation de fréquence, interne au microprocesseur et commandé par des moyens de défilement de la bande de fréquence.

Dans le but de faire face à un régime dégradé, le dispositif conforme au préambule de la revendication 1 est remarquable en ce que, lesdits moyens d'accord et de verrouillage étant réalisés par un synthétiseur de fréquence, en coopération avec un dispositif d'incrémentation de fréquence, interne au microprocesseur et commandé par des moyens de défilement de la bande de fréquence, le microprocesseur est relié à une mémoire non volatile qui conserve en permanence les derniers ordres de télécommande. Dans le cas d'une application à la télécommande d'organes de rupture, la mémoire non volatile conserve alors l'état ouvert ou fermé des organes de rupture. Cette disposition permet, après coupure du courant ou tout autre incident, de revenir à la dernière position desdits organes de rupture. Dans le même ordre d'idée, deux autres mesures de sauvegarde sont envisagées. D'une part, la valeur de la fréquence de l'onde porteuse et les valeurs de consigne permettant le fonctionnement autonome du dispositif récepteur en cas de carence de l'émetteur de l'onde porteuse, sont inscrites dans ladite mémoire non volatile. D'autre part, la mémoire non volatile conserve également les valeurs de consigne initiales telles que définies à l'installation du dispositif récepteur, ce qui permet d'avoir toujours la possibilité de revenir à ces valeurs même si elles ont été modifiées un certain nombre de fois.

Dans un souci d'économie, on envisage que les moyens de défilement de la bande de fréquence font partie d'un boîtier de commande amovible, ce qui permet d'utiliser un seul boîtier pour mettre en service plusieurs dispositifs récepteurs de télécommande selon l'invention situés à des endroits différents. Il est également prévu que le boîtier de commande comporte un afficheur donnant la valeur de la fréquence d'accord. Ainsi, l'installateur du dispositif récepteur de télécommande pourra facilement accorder l'oscillateur local sur la fréquence de l'onde porteuse, il suffira pour cela d'agir sur les moyens de défilement de la bande de fréquence jusqu'à ce que la valeur de la fréquence de l'onde porteuse, préalablement connue, apparaisse sur l'afficheur. Afin de s'assurer que l'accord ainsi réalisé est satisfaisant, il est envisagé que le boîtier de commande comporte un indicateur de niveau de champ permettant de contrôler l'intensité de l'onde porteuse.

La description qui va suivre, en regard du dessin annexé, donné à titre d'exemple non limitatif, fera bien comprendre en quoi consiste l'invention et comment elle peut être réalisée.

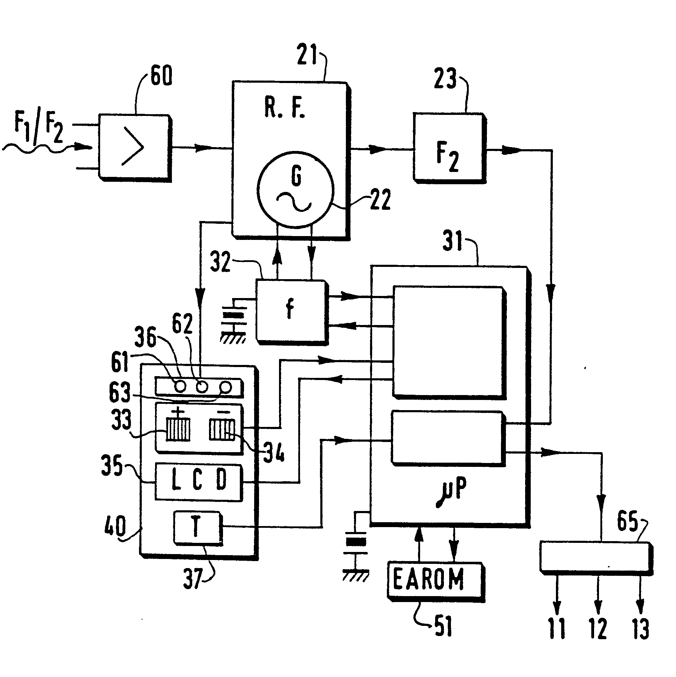

La figure 1 est un schéma synoptique d'un dispositif récepteur de télécommande selon l'invention.

Le schéma synoptique de la figure 1 montre un dispositif récepteur de télécommande, par exemple d'organes de rupture 11, 12, 13, utilisant une onde porteuse de fréquence $F_1$, modulée en amplitude, en fréquence ou en phase, à la fréquence $F_2$. Cette onde porteuse contient des informations de télécommande et comporte un poste récepteur 21, muni d'un oscillateur local 22, qui reçoit ladite onde porteuse via un circuit d'adaptation 60. Un démodulateur 23 de la modulation à la fréquence $F_2$ délivre en sortie,

sous forme d'informations digitales, les ordres de télécommande. Comme on peut le voir à la figure 1, le dispositif récepteur comporte également, d'une part, un microprocesseur 31 permettant, en autres, de gérer les ordres de télécommande à partir des informations digitales fournies par le démodulateur 23, et, d'autre part, des moyens d'accord et de verrouillage de la fréquence de l'oscillateur local 22 sur la fréquence $F_1$ de l'onde porteuse. Dans l'exemple de la figure 1, ces moyens d'accord et de verrouillage sont réalisés par un synthétiseur de fréquence 32, en coopération avec un dispositif d'incrémentation de fréquence, interne au microprocesseur 31, et commandé par des moyens de défilement de la bande de fréquence, ici des boutons-poussoirs 33, 34 assurant le défilement de la fréquence dans le sens montant ou descendant.

Le microprocesseur 31 est relié à une mémoire non volatile 51 dans laquelle sont inscrites la valeur de la fréquence $F_1$ de l'onde porteuse et les valeurs de consigne permettant le fonctionnement autonome du dispositif récepteur selon l'invention en cas de carence de l'émetteur de l'onde porteuse. En effet, en régime dégradé, la fréquence inscrite dans la mémoire non volatile 51 est appliquée au synthétiseur de fréquence 32 qui accorde alors l'oscillateur local 22 sur la fréquence $F_1$ de l'onde porteuse, assurant ainsi la continuité de fonctionnement du dispositif. De même, il est prévu que la mémoire non volatile 51 conserve les valeurs de consigne initiales telles que définies à l'installation du dispositif récepteur, offrant ainsi la possibilité de revenir à ces valeurs initiales après qu'elles aient été modifiées une ou plusieurs fois. Enfin, la mémoire non volatile 51 conserve en permanence les derniers ordres de télécommande, c'est à dire, par exemple, les états "ouvert" ou "fermé" des organes de rupture 11, 12, 13. Ainsi, après une coupure de courant ou tout autre incident, cette mesure de sauvegarde permet de revenir à la position initiale des organes de rupture.

Dans une forme particulière de réalisation de l'invention, les moyens 33, 34 de défilement de la bande de fréquence font partie d'un boîtier 40 de commande amovible du type enfichable ou à connexion par cables, ou encore, à couplage infrarouge ou ultra-sonore. Cette disposition économique offre la possibilité de mettre en service, avec le même boîtier de commande, plusieurs dispositifs récepteurs de télécommande selon l'invention. Ainsi que le montre la figure 1, le boîtier 40 de commande comporte également un afficheur 35, par exemple à cristaux liquides, donnant la valeur de la fréquence d'accord. En outre un indicateur 36 de niveau de champ permet de contrôler l'intensité de l'onde porteuse reçue. Dans l'exemple donné à la figure 1, cet indicateur 36 est composé de trois diodes électroluminescentes 61, 62, 63 correspondant à trois niveaux d'intensité donnés.

Pour mettre en service le dispositif récepteur de télécommande selon l'invention, il suffit de faire apparaître sur l'afficheur 35 la valeur connue de la fréquence $F_1$ en agissant sur les moyens 33, 34 de défilement et de contrôler, grâce à l'indicateur 36 de niveau de champ, que l'intensité de l'onde porteuse reçue est suffisante. Par ailleurs, comme le montre la figure 1, il est prévu des moyens de test 37 permettant de s'assurer de la bonne transmission, par l'intermédiaire de l'interface 65, des ordres de télécommande aux organes 11, 12, 13 à commander.

Enfin, on peut encore envisager que le boîtier 40 de commande comporte un clavier à touches permettant à l'utilisateur de composer les numéros de code d'identification et des ordres à recevoir et de les valider.

## Revendications

1. Dispositif récepteur de télécommande utilisant une onde porteuse modulée, de fréquence ($F_1$), contenant des informations de télécommande, et comportant un poste récepteur (21), muni d'un oscillateur local (22), et un démodulateur (23) qui délivre en sortie les ordres de télécommande sous forme d'informations digitales, dispositif comportant également, d'une part, un microprocesseur (31) permettant, entre autres, de gérer les ordres de télécommande à partir des informations digitales fournies par le démodulateur (23), et, d'autre part, des moyens d'accord et de verrouillage de la fréquence de l'oscillateur local (22) sur la fréquence ($F_1$) de l'onde porteuse, caractérisé en ce que, lesdits moyens d'accord et de verrouillage étant réalisés par un synthétiseur de fréquence (32), en coopération avec un dispositif d'incrémentation de fréquence, interne au microprocesseur (31) et commandé par des moyens (33, 34) de défilement de la bande de fréquence, le microprocesseur (31) est relié à une mémoire non volatile (51) qui conserve en permanence les derniers ordres de télécommande.

2. Dispositif récepteur selon la revendication 1, caractérisé en ce que la valeur de la fréquence ($F_1$) de l'onde porteuse et les valeurs de consigne permettant le fonctionnement autonome du dispositif récepteur en cas de carence de l'émetteur de l'onde porteuse, sont inscrites dans ladite mémoire non volatile (51).

3. Dispositif récepteur selon la revendication 2, caractérisé en ce que la mémoire non volatile (51) conserve également les valeurs de consigne initiales telles que définies à l'installation du dispositif récepteur.

4. Dispositif récepteur selon la revendication 2, caractérisé en ce que les moyens (33, 34) de défilement de la bande de fréquence font partie d'un boîtier (40) de commande amovible.

5. Dispositif récepteur selon la revendication 4, caractérisé en ce que le boîtier (40) de commande comporte un afficheur (35) donnant la valeur de la fréquence d'accord.

6. Dispositif récepteur selon l'une quelconque des revendications 4 ou 5, caractérisé en ce que le boîtier (40) de commande comporte un indicateur (36) de niveau de champ permettant de contrôler l'intensité de l'onde porteuse.

7. Dispositif récepteur selon l'une des revendications 4 à 6, caractérisé en ce que le boîtier (40) de commande comporte des moyens (37) de test gérés par le microprocesseur (31) permettant de s'assurer du bon fonctionnement du dispositif récepteur.

8. Dispositif récepteur selon l'une des revendications 4 à 7, caractérisé en ce que le boîtier (40) de commande est du type enfichable.

9. Dispositif récepteur selon l'une des revendications 4 à 7, caractérisé en ce que le boîtier (40) de commande est du type à connexion par cables.

10. Dispositif récepteur selon l'une des revendications 4 à 7, caractérisé en ce que le boîtier (40) de commande est du type à couplage infrarouge.

11. Dispositif récepteur selon l'une des revendications 4 à 7, caractérisé en ce que le boîtier (40) de commande est du type à couplage ultrasonore.

12. Dispositif récepteur selon l'une des revendications 4 à 11, caractérisé en ce que le boîtier (40) de commande comporte un clavier à touches permettant à l'utilisateur de composer les numéros de code d'identification et des ordres à recevoir et de les valider.

## Patentansprüche

1. Fernsteuerempfangsanordnung unter Anwendung einer modulierten Trägerwelle mit einer Frequenz ($F_1$), die Fernsteuerdaten aufweist, und mit einer Empfangsstelle (21), die mit einem Ortsoszillator (22) und einem Demodulator (23) versehen ist, der die Fernsteuerbefehle in Form digitaler Signale an dem Ausgang liefert, wobei diese Anordnung ebenfalls einerseits einen Mikroprozessor (31) aufweist, u. a. zur Regelung der Fernsteuerbefehle aus den digitalen Daten, die von dem Demodulator (23) geliefert werden und andererseits Mittel zum Abstimmen und Verriegeln der Frequenz des Ortsoszillators (22) auf der Trägerfrequenz ($F_1$), dadurch gekennzeichnet, dass die genannten Abstimm- und Verriegelungsmittel durch einen Frequenzgenerator mit Frequenzsynthese (32) zusammen mit einer Frequenzverstimmungsanordnung in dem Mikroprozessor (31) gebildet werden und durch Mittel (33, 34) zum Lauf durch das Frequenzband gesteuert werden und dass der Mikroprozessor (31) mit einem nicht flüchtigen Speicher (51) verbunden ist, der die letzten Fernsteuerbefehle ständig speichert.

2. Empfangsanordnung nach Anspruch 1, dadurch gekennzeichnet, dass der Wert der Trägerfrequenz ($F_1$) und die Informationswerte, die das selbsttätige Funktionieren der Empfangsanordnung im Falle eines Fehlers der Trägerwelle ermöglichen, in dem genannten nicht flüchtigen Speicher (51) eingeschrieben sind.

3. Empfangsanordnung nach Anspruch 2, dadurch gekennzeichnet, dass der nicht flüchtige Speicher (51) ebenfalls die Anfangsinformationswerte speichert, wie diese bei der Installation der Empfangsanordnung definiert wurden.

4. Empfangsanordnung nach Anspruch 2, dadurch gekennzeichnet, dass die Mittel (33, 34) für den Lauf durch das Frequenzband einen Teil eines herausnehmbaren Steuerkastens (40) bilden.

5. Empfangsanordnung nach Anspruch 4, dadurch gekennzeichnet, dass der Steuerkasten (40) eine Anzeige (35) ausweist, die den Wert der Abstimmfrequenz angibt.

6. Empfangsanordnung nach einem der Ansprüche 4 oder 5, dadurch gekennzeichnet, dass der Steuerkasten (40) eine Feldpegelanzeige (36) aufweist, durch die es möglich ist, die Intensität der Trägerwelle zu überprüfen.

7. Empfangsanordnung nach einem der Ansprüche 4 bis 6, dadurch gekennzeichnet, dass der Steuerkasten (40) Überprüfungsmittel (37) aufweist, die durch den Mikroprozessor (31) gesteuert werden, durch die es möglich ist, sich vom einwandfreien Funktionieren der Empfangsanordnung zu überzeugen.

8. Empfangsanordnung nach einem der Ansprüche 4 bis 7, dadurch gekennzeichnet, dass der Steuerkasten (40) vom Einstecktyp ist.

9. Empfangsanordnung nach einem der Ansprüche 4 bis 7, dadurch gekennzeichnet, dass der Steuerkasten (40) von dem Typ mit Kabelverbindung ist.

10. Empfangsanordnung nach einem der Ansprüche 4 bis 7, dadurch gekennzeichnet, dass der Steuerkasten (40) von dem Typ mit Infrarotkopplung ist.

11. Empfangsanordnung nach einem der Ansprüche 4 bis 7, dadurch gekennzeichnet, dass der Steuerkasten (40) von dem Typ mit Ultraschallkopplung ist.

12. Empfangsanordnung nach einem der Ansprüche 4 bis 11, dadurch gekennzeichnet, dass der Steuerkasten (40) einen Tastensatz aufweist, durch den der Benutzer die Kenncodenummern und die zu empfangenden Befehle zusammenstellen und freigeben kann.

## Claims

1. A remote control receiver arrangement using a modulated carrier having a frequency ($F_1$) containing remote control data and comprising a receiver (21) provided with a local oscillator (22) and a demodulator (23) which supplies the remote control commands in the form of digital data at its output, said arrangement also comprising on the one hand a microprocessor (31), inter alia, far managing the remote control commands from digital data supplied by the demodulator (23) and on the other hand means for tuning and locking the frequency of the local oscillator (22) on the carrier frequency ($F_1$), characterized in that the said tuning and locking means are constituted by a fequency synthesiser (32) in cooperation with a frequency-incrementing arrangement incorporated in the microprocessor (31) and controlled by means (33, 34) for moving through the frequency band, and in that the microprocessor (31) is connected to a non-volatile memory (51) which permanently preserves the last remote control commands.

2. A receiver arrangement as claimed in Claim 1, characterized in that the value of the carrier frequency ($F_1$) and the values of the access signal, permitting of independent functioning of the receiver arrangement in the case of default of the carrier transmitter are written in the said non-volatile memory (51).

3. A receiver arrangement as claimed in Claim 2, characterized in that the non-volatile memory (51) also preserves the initial values of the access signal such as have been defined upon installation of the receiver arrangement.

4. A receiver arrangement as claimed in Claim 2, characterized in that the means (33, 34) for moving through the frequency band form part of a portable control box (40).

5. A receiver arrangement as claimed in Claim 4, characterized in that the control box (40) comprises a display (35) indicating the value of the tuning frequency.

6. A receiver arrangement as claimed in any one of Claim 4 or 5, characterized in that the control box (40) comprises a field level indicator (36) for checking the strength of the carrier.

7. A receiver arrangement as claimed in any one of Claims 4 to 6, characterized in that the control box (40) comprises test means (37) managed by the microprocessor (31) ensuring a satisfactory functionig of the receiver arrangement.

8. A receiver arrangement as claimed in any one of Claims 4 to 7, characterized in that the control box (40) is of the plug-in type.

9. A receiver arrangement as claimed in any one of Claims 4 to 7, characterized in that the control box (40) is of the cable-connection type.

10. A receiver arrangement as claimed in any one of claims 4 to 7, characterized in that the control box (40) is of the infrared coupling type.

11. A receiver arrangement as claimed in any one of Claims 4 to 7, characterized in that the control box (40) is of the ultrasonic coupling type.

12. A receiver arrangement as claimed in any one of claims 4 to 11, characterized in that the control box (40) has a push-button keyboard rendering it possible for the user to compose the identification-code numbers and commands to be received and to evaluate them.